# EUROPEAN PATENT APPLICATION

(11) **EP 2 597 645 A2**
(43) Date of publication of application: **29.05.2013**
(21) Application number: 12194403.7
(22) Date of filing: 27.11.2012
(51) Int. Cl.: G11C 5/04, G11C 8/06, G11C 7/10, G11C 11/408

(54) **Memory module**

(30) Priority: 28.11.2011 JP 2011259471
(71) Applicant: Elpida Memory, Inc., Tokyo 104-0028 (JP)
(72) Inventor: Osanai, Fumiyuki, Tokyo, 104-0028 (JP); Sugano, Toshio, Tokyo, 104-0028 (JP); Hiraishi, Atsushi, Tokyo, 104-0028 (JP)
(74) Representative: Vossius & Partner

(57) **Abstract**

Disclosed herein is a memory module that includes a plurality of command address connectors formed on the module substrate, a plurality of memory devices mounted on the module substrate, and a plurality of command address register buffers mounted on the module substrate. The command address connectors receive a command address signal from outside.

The memory devices include a plurality of first memory devices and a plurality of second memory devices. The command address register buffers include a first command address register buffer that supplies the command address signal to the first memory devices and a second command address register buffer that supplies the command address signal to the second memory devices.

## Description

### BACKGROUND OF THE INVENTION

### --Field of the Invention

The present invention relates to a memory module, and more particularly to a memory module that includes a command address register buffer for supplying a command address signal to memory devices.

### --Description of Related Art

Memory modules such as a dual inline memory module (DIMM) are configured so that a large number of memory chips such as dynamic random access memories (DRAMs) are mounted on a module substrate. Such a memory module is inserted into a memory slot arranged on a motherboard, whereby data transfer between the memory module and a memory controller is performed. Memory capacities that are required by the system have been extremely large in recent years, and it is difficult for a single memory module to provide a needed memory capacity. Most motherboards have a plurality of memory slots so that a plurality of memory modules can be mounted.

If a plurality of memory modules are mounted on the motherboard, the load capacitance of command address wirings on the motherboard increases to deteriorate signal quality. Such a problem is not significant when a frequency of a clock signal is rather low. If the frequency of the clock signal is high, a problem occurs because proper signal transfer fails due to deterioration of signal quality of the command address signal.

Memory modules called load reduced memory modules are known to be capable of reducing the load capacitance of the command address wirings (see Japanese Patent Application Laid-Open No. 2010-282510). The load reduced memory module described in Japanese Patent Application Laid-Open No. 2010-282510 includes a command address register buffer. The command address register buffer functions to buffer the command address signal supplied from a memory controller and supply the command address signal to a plurality of memory chips.

In the memory module described in Japanese Patent Application Laid-Open No. 2010-282510, the command address register buffer needs to supply the command address signal in common to all of the memory chips mounted on the memory module. Therefore, when a number of memory chips are mounted on the memory module, the load capacitance of command address wirings on the memory module increases to deteriorate signal quality of the command address signal.

### SUMMERY

A memory module according to the present invention includes: a module substrate; a plurality of command address connectors formed on the module substrate, the command address connectors receiving a command address signal from outside; a plurality of memory devices mounted on the module substrate, the memory devices including a plurality of first memory devices and a plurality of second memory devices; and a plurality of command address register buffers mounted on the module substrate, the command address register buffers including a first command address register buffer that supplies the command address signal to the first memory devices and a second command address register buffer that supplies the command address signal to the second memory devices.

According to the present invention, a load of the wirings on the module substrate can be reduced even if a number of the memory chips are mounted on the module substrate because a plurality of the command address register buffers are employed. Therefore, a signal integrity of the command address signal that is to be supplied to the memory chips is improved.

### BRIEF DESCRIPTION OF THE DRAWINGS

FIG. 1 is a schematic diagram showing the configuration of a memory module according to a first embodiment of the present invention;
FIG. 2A shows the layout of the devices mounted on the one main surface of the module substrate according to the first embodiment;
FIG. 2B shows the layout of the devices mounted on the other main surface of the module substrate according to the first embodiment;
FIG. 3 is a perspective view schematically showing the structure of an information processing system which includes the memory module shown in FIG. 1;
FIG. 4 is a block diagram showing the configuration of a memory chip included in memory module according to the first embodiment;
FIG. 5 is a schematic plan view for describing the arrangement of external terminals formed on the memory chip shown in FIG. 4;
FIG. 6 is a block diagram showing the configuration of a data register buffer included in memory module according to the first embodiment;
FIG. 7 is a schematic plan view for describing the arrangement of external terminals formed on the data register buffer shown in FIG. 6;
FIG. 8 is a block diagram showing the configuration of the command address register buffer included in memory module according to the first embodiment;
FIG. 9 is a schematic plan view for describing the arrangement of external terminals formed on the command address register buffer shown in FIG. 8;
FIG. 10 is a block diagram for describing the connections of the devices included in the memory module according to the first embodiment;
FIG. 11 is a schematic diagram for describing the connections between the data connectors and the memory chips;
FIG. 12 is a schematic diagram for describing the connections between the command address connectors and the memory chips;
FIG. 13 is a schematic diagram for describing the connections between the command address register buffers and the memory chips according to the first embodiment;
FIG. 14 is a schematic diagram for describing the connections between the command address register buffer and the memory chips of a prototype memory module which the inventors have conceived in the process of achieving the present invention;
FIG. 15 is an enlarged cross sectional view of the module substrate according to the first embodiment;
FIG. 16 is a schematic diagram for describing the connections between the command address register buffers and the memory chips according to the prototype memory module;
FIG. 17 is a schematic diagram showing the configuration of a memory module according to the second embodiment of the present invention;
FIG. 18A shows the layout of the devices mounted on one main surfaces of the module substrate according to the second embodiment;
FIG. 18B shows the layout of the devices mounted on the other main surface of the module substrate according to the second embodiment;
FIG. 19 is a schematic diagram showing the configuration of a memory module according to the third embodiment of the present invention;
FIG. 20 is a schematic diagram showing the configuration of a memory module according to the fourth embodiment of the present invention;
FIG. 21A shows an eye pattern of the command address signals and the control signals according to the first and second embodiments; and
FIG. 21B shows an eye pattern of the command address signals and the control signals according to the prototype example shown in FIG. 14.

### DETAILED DESCRIPTION OF THE EMBODIMENTS

Preferred embodiments of the present invention will be explained below in detail with reference to the accompanying drawings.

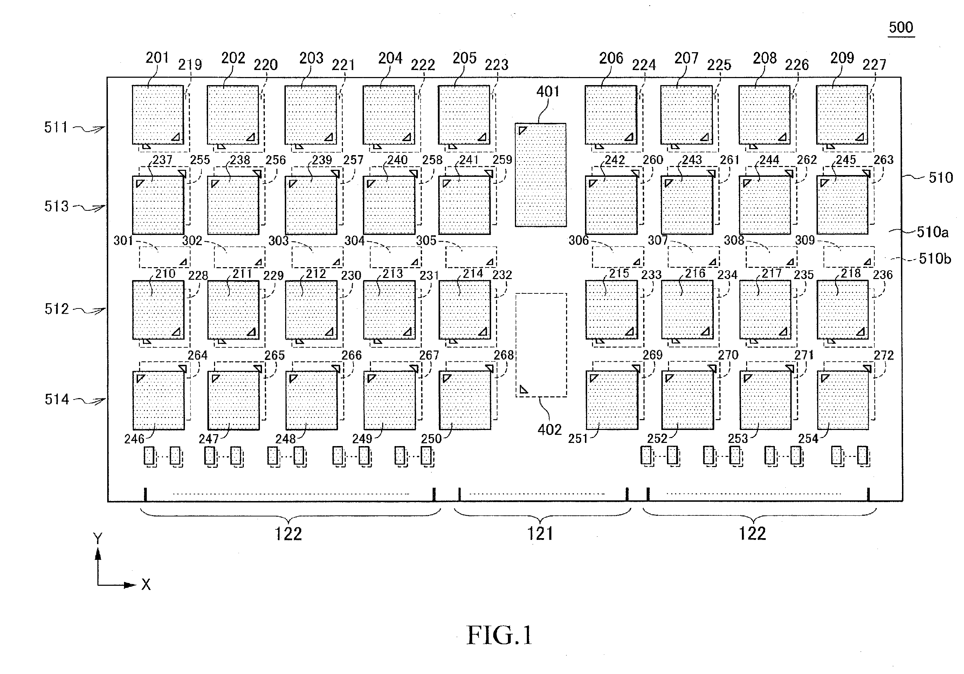

Referring now to FIG. 1, the memory module 500 according to the first embodiment of the present invention includes a module substrate 510, and 72 memory chips 201 to 272, nine data register buffers 301 to 309, and two command address register buffers 401 and 402 which are mounted on the module substrate 510. As employed herein, the memory chips 201 to 272 may be referred to simply as "memory chips 200" if no distinction is needed. Similarly, the data register buffers 301 to 309 may be referred to simply as "data register buffers 300" if no distinction is needed. The command address register buffers 401 and 402 may be referred to simply as "command address register buffers 400" if no distinction is needed.

The module substrate 510 is a printed circuit board having multilayer wiring. The module substrate 510 has a generally rectangular planar shape with a long side in the X direction shown in FIG. 1 and a short side in the Y direction. A plurality of connectors 120 are formed on one of the sides of the module substrate 510 along the X direction, the long side. The connectors 120 are terminals for establishing electrical connections with a memory controller through a memory slot to be described later. The connectors 120 are classified into command address connectors 121 to which a command address signal CA and a control signal CTRL are supplied from the memory controller, and data connectors 122 which are intended to supply read data to the memory controller or input write data from the memory controller. In the present embodiment, the number of pins of the data connectors 122 is, though not limited to, 72. Consequently, 72 bits of read data or write data can be simultaneously input or output.

The "command address signal CA" refers to a group of signals including an address signal ADD and a command signal CMD. The address signal ADD may include a bank address. The command signal CMD refers to a group of signals including a row address strobe signal RASB, a column address strobe signal CASB, and a write enable signal WEB.

The "control signal CTRL" refers to a group of signals including clock signals CK and CKB, chip select signals CS0B to CS3B, clock enable signals CKE0 and CKE1, and on-die termination signals ODT0 and ODT1. The clock signals CK and CKB are complementary signals. The chip select signals CS0B to CS3B and the clock enable signals CKE0 and CKE1 are signals for activating respective corresponding ranks (to be described later). The on-die termination signals ODT0 and OBT1 are signals for making respective corresponding ranks function as a termination resistor. As employed herein and in the drawings, if no distinction is needed, the clock signals CK and CKB may be referred to correctively as a clock signal CK. The chip select signals CS0B to CS3B may be referred to collectively as a chip select signal CSB. The clock enable signals CKE0 and CKE1 may be referred to collectively as a clock enable signal CKE. The on-die termination signals ODTO and ODT1 may be referred to collectively as an on-die termination signal ODT. Such signals may be referred to collectively as a control signal CTRL.

Examples of the memory chips 201 to 272 are DRAMs. Of these, 36 memory chips 201 to 218 and 237 to 254 are mounted on one of the main surfaces 510a af the module substrate 510. The remaining 36 memory chips 219 to 236 and 255 to 272 are mounted on the other main surface 510b of the module substrate 510. The memory chips 201 to 218, 237 to 254 and the memory chips 219 to 236, 255 to 272 are mounted in respective opposite positions of the module substrate 510. When seen in a plan view, the memory chips 201 to 218, 237 to 254 and the memory chips 219 to 236, 255 to 272 are arranged in respective overlapping positions. For example, the memory chip 201 and the memory chip 219 are mounted on the front and back of the module substrate 510 in the same planar position, i.e., at the same X and Y coordinates. For ease of visualization, FIG. 1 shows each pair of memory chips 200 arranged on the front and back of the module substrate 510 in staggered planar positions. In fact, such memory chips 200 are in the same planar position as described above. As employed herein, "in a plan view" means being seen in a direction (Z direction) orthogonal to the X direction and the Y direction.

In FIG. 1, the triangular marks on the chips are orientation marks indicating the mounting directions of the chips. The same kind of chips with the orientation marks in the same positions are mounted in the same direction. Specifically, the memory chips 201 to 218 are mounted in the same directions. The memory chips 219 to 236 are mounted in the same direction. The memory chips 237 to 254 are mounted in the same direction. The memory chips 255 to 272 are mounted in the same direction. The memory chips 201 to 218 and the memory chips 237 to 254 are mounted in 180° different directions. The memory chips 219 to 236 and the memory chips 255 to 272 are mounted in 180° different directions. The memory chips 201 to 218 and the memory chip 219 to 236 lying on the front and back are mounted in the same directions. The memory chips 237 to 254 and the memory chips 255 to 272 lying on the front and back are mounted in the same directions. Note that the data register buffers 301 to 309 are mounted in the same direction.

As shown in FIG. 1, the memory module 500 according to the first embodiment of the present invention employs two command address register buffers 401 and 402. The command address register buffers 401 and 402 are chips having the same configuration. The command address register buffer 401 is mounted on one of the main surfaces 510a of the module substrate 510. The command address register buffer 402 is mounted on the other main surface 510b of the module substrate 510. The mounting direction of the command address register buffer 401 with respect to the one main surface 510a and the mounting direction of the command address register buffer 402 with respect to the other main surface 510b are 180° different from each other.

The memory module 500 according to the present embodiment has a so-called four-rank configuration. A rank refers to a memory space to be exclusively selected. The same addresses are assigned to the ranks. Either one of the ranks is selected by exclusively activating one of the chip select signals CS0B to CS3B and exclusively activating the clock enable signal CKE0 or CKE1. In the present embodiment, the memory chips 201 to 218 mounted on the one main surface 510a of the module substrate 510 constitute rank0. The memory chips 255 to 272 mounted on the other main surface 510b of the module substrate 510 constitute rank1. The memory chips 237 to 254 mounted on the one main surface 510a of the module substrate 510 constitute rank2. The memory chips 219 to 236 mounted on the other main surface 510b of the module substrate 510 constitute rank3.

As shown in FIG. 1, the memory chips 201 to 272 are arranged in four rows on the module substrate 510 when seen in a plan view. More specifically, the memory chips 201 to 209 and 219 to 227 are arranged in a first row 511 which is the uppermost row. The memory chips 237 to 245 and 255 to 263 are arranged in a third row 513 which is the second uppermost row. The memory chips 210 to 218 and 228 to 236 are arranged in a second row 512 which is the second lowermost row. The memory chips 246 to 254 and 264 to 272 are arranged in a fourth row 514 which is the lowermost row. The memory chips arranged in the same have the same X coordinates. In other words, the memory chips are arranged in the Y direction when seen in a plan view. For example, the memory chips 201, 210, 219, 228, 237, 246, 255 and 264 have the same X coordinate. The same holds for the other corresponding memory chips.

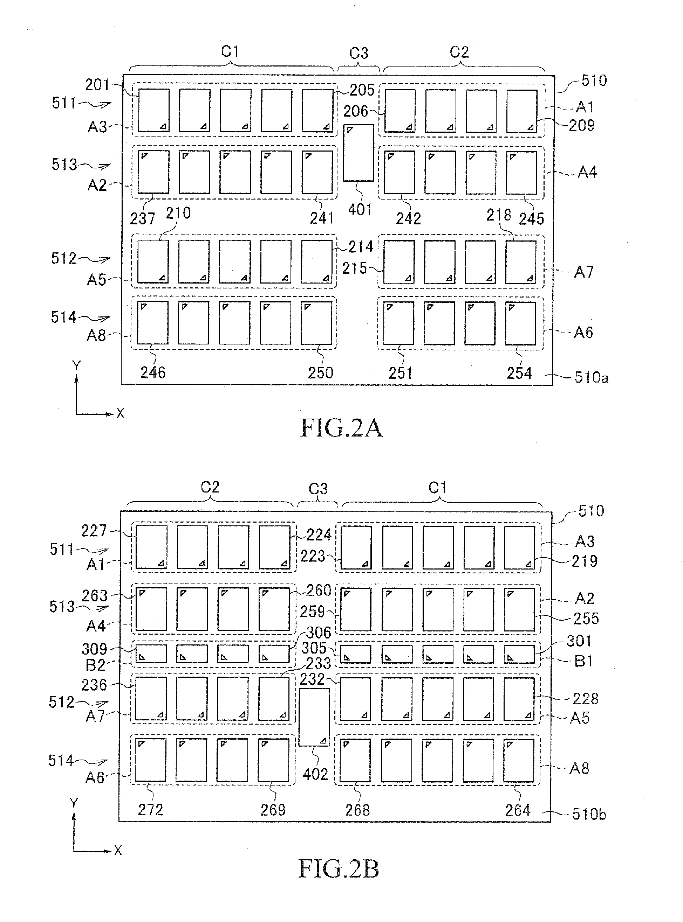

The mounting positions of the memory chips 200, the data register buffers 300 and the command address register buffers 400 on the module substrate 510 will be explained in more detail with reference to FIGs. 2A and 2B.

As shown in FIG. 2A and 2B, the module substrate 510 includes eight memory mounting areas A1 to A8 on which a plurality of memory chips 200 are mounted. The memory mounting areas A2, A3, A5 and A8 are defined in the first region C1. The memory mounting areas A1, A4, A6 and A7 are defined in the second region C2. The first and second regions C1 and C2 are arranged in the X direction. The module substrate 510 includes the third region C3 that is disposed between the first and second regions C1 and C2. The command address register buffers 401 and 402 are mounted on the third region C3.

Configurations of the memory mounting areas A1 to A8 will be explained in detail with reference to FIG. 2A and 2B. As shown in FIG. 2A and 2B, the first region C1 includes the third memory mounting area A3 on the first row 511, the fifth memory mounting area A5 on the second row 512, the second memory mounting area A2 on the third row 513, and the eighth memory mounting area A8 on the fourth row 514. The memory chips 201 to 205 arranged in the X direction are mounted on one main surface 510a of the module substrate 510 in the third memory mounting area A3. The memory chips 219 to 223 arranged in the X direction are mounted on the other main surface 510b of the module substrate 510 in the third memory mounting area A3. The memory chips 210 to 214 arranged in the X direction are mounted on the one main surface 510a of the module substrate 510 in the fifth memory mounting area A5. The memory chips 228 to 232 arranged in the X direction are mounted on the other main surface 510b of the module substrate 510 in the fifth memory mounting area A5. The memory chips 237 to 241 arranged in the X direction are mounted on the one main surface 510a of the module substrate 510 in the second memory mounting area A2. The memory chips 255 to 259 arranged in the X direction are mounted on the other main surface 510b of the module substrate 510 in the second memory mounting area A2. The memory chips 246 to 250 arranged in the X direction are mounted on the one main surface 510a of the module substrate 510 in the eighth memory mounting area A8. The memory chips 264 to 268 arranged in the X direction are mounted on the other main surface 510b of the module substrate 510 in the eighth memory mounting area A8.

The second region C2 includes the first memory mounting area A1 on the first row 511, the seventh memory mounting area A7 on the second row 512, the fourth memory mounting area A4 on the third row 513, and the sixth memory mounting area A6 on the fourth row 514. The memory chips 206 to 209 arranged in the X direction are mounted on the one main surface 510a of the module substrate 510 in the first memory mounting area A1. The memory chips 224 to 227 arranged in the X direction are mounted on the other main surface 510b of the module substrate 510 in the first memory mounting area A1. The memory chips 215 to 218 arranged in the X direction are mounted on the one main surface 510a of the module substrate 510 in the seventh memory mounting area A7. The memory chips 233 to 236 arranged in the X direction are mounted on the other main surface 510b of the module substrate 510 in the seventh memory mounting area A7. The memory chips 242 to 245 arranged in the X direction are mounted on the one main surface 510a of the module substrate 510 in the fourth memory mounting area A4. The memory chips 260 to 263 arranged in the X direction are mounted on the other main surface 510b of the module substrate 510 in the fourth memory mounting area A4. The memory chips 251 to 254 arranged in the X direction are mounted on the one main surface 510a of the module substrate 510 in the sixth memory mounting area A6. The memory chips 269 to 272 arranged in the X direction are mounted on the other main surface 510b of the module substrate 510 in the sixth memory mounting area A6.

In this disclosure, the memory chips mounted on the first to eighth memory mounting areas A1 to A8 may be referred to as first to eighth memory devices, respectively.

Of the memory chips 201 to 272 mounted on the memory mounting areas A1 to A8, eight memory chips having the same X coordinate are connected in common to one of the data register buffers 300 that has the same X coordinate. For example, the memory chips 201, 210, 219, 228, 237, 246, 255 and 264 are connected in common to the data register buffer 301. The data register buffers 300 function to supply write data supplied from the corresponding data connectors 122 to the corresponding memory chips 200, and supply read data supplied from the corresponding memory chips 200 to the corresponding data connectors 122. For example, write data to be written to the memory chips 201, 210, 219, 228, 237, 246, 255 and 264 is buffered by the data register buffer 301. Read data read from the memory chips 201, 210, 219, 228, 237, 246, 255 and 264 is buffered by the register buffer 301.

As shown in FIG. 2B, the data register buffers 301 to 309 are arranged in the X direction in a register mounting areas B1 and B2 which are sandwiched between the third row 513 and the second row 512 when seen in a plan view. In the present embodiment, the register mounting areas B1 and B2 are defined on, though not limited to, the other main surface 510b of the module substrate 510. The register mounting area B1 is arranged between the second and fifth memory mounting areas A2 and A5. The register mounting area B2 is arranged between the fourth and seventh memory mounting areas A4 and A7. The data register buffers 301 to 305 are arranged in the X direction on the register mounting area B1. The data register buffers 306 to 309 are arranged in the X direction on the register mounting area B2.

As shown in FIG. 2A, the command address register buffer 401 is mounted on the one main surface 510a of the module substrate 510 at the third region C3. As shown in FIG. 2B, the command address register buffer 402 is mounted on the other main surface 510b of the module substrate 510 at the third region C3.

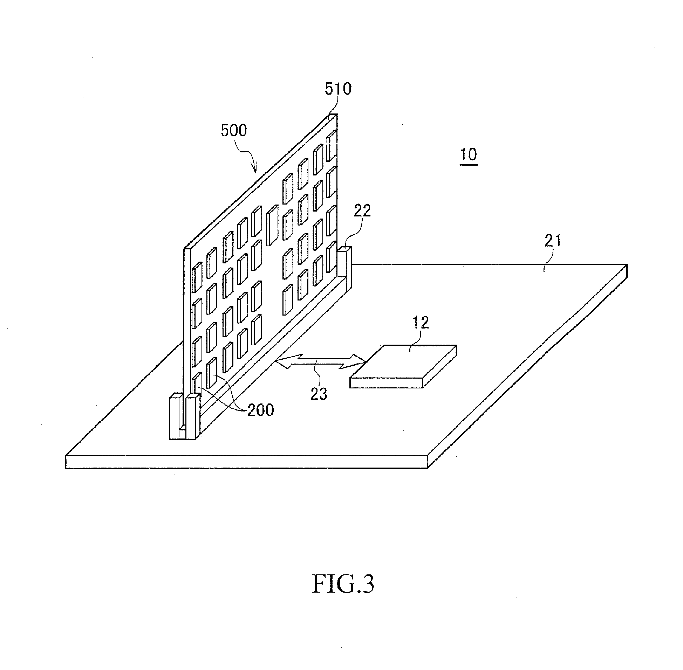

The structure of an information processing system 10 that includes the memory module 500 will be explained with reference to FIG. 3.

As shown in FIG. 3, the information processing system 10 is constructed on a motherboard 21. The motherboard 21 includes a memory slot 22. The memory module 500 according to the present embodiment is inserted into the memory slot 22. A memory controller 12 is mounted on the motherboard 21. The memory controller 12 is connected to the memory module 500 through wiring 23 formed on the motherboard 21. Note that the memory controller 12 is not directly connected to the memory chips 200 on the memory module 500, but connected to the memory chips 200 through the data register buffers 301 to 309 and the command address register buffers 401 and 402. Such a connection reduces the load capacitance of the signal path connecting the memory controller 12 and the memory module 500, whereby favorable signal quality can be provided even at a high data transfer rate.

While the information processing system 10 shown in FIG. 3 has only one memory slot 22 on the motherboard 21, actual memory systems may include a plurality (for example, four) of memory slots. The memory module 500 is mounted on each of the memory slots. If a plurality of memory modules 500 are mounted, the load capacitance of the signal path increases accordingly. In the present embodiment, the load capacitance per memory module is extremely small as compared to heretofore, and fast data transfer is possible even when a plurality of memory modules are mounted.

Next, the configuration of the memory chips 200 will be described.

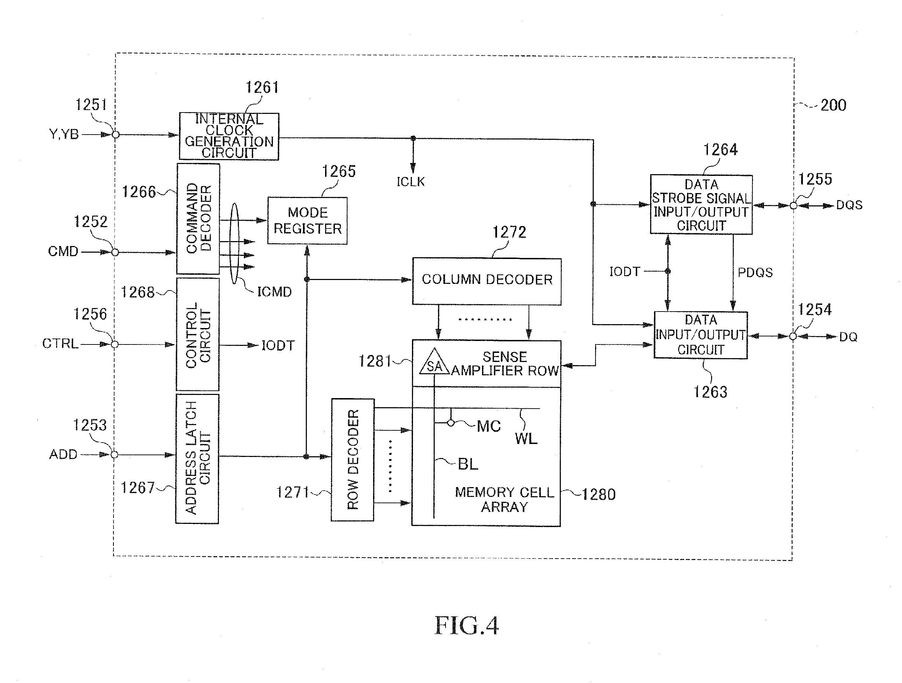

The memory chip 200 is a DRAM. As shown in FIG. 4, the memory chip 200 has a clock terminal 1251, a command terminal 1252, a control terminal 1256, an address terminal 1253, a data input/output terminal 1254, and a data strobe terminal 1255 as external terminals. Of these, the clock terminal 1251, the command terminal 1252, the control terminal 1256, and the address terminal 1253 are connected to corresponding one of the command address register buffer 401 and 402. The data input/output terminal 1254 and the data strobe terminal 1255 are connected to a corresponding data register buffer 300. The memory chip 200 also includes other terminals such as a power supply terminal, which are omitted from the diagram.

The clock terminal 1251 is a terminal to which complementary clock signals Y and YB are supplied. The supplied clock signals Y and YB are supplied to an internal clock generation circuit 1261. The internal clock generation circuit 1261 generates an internal clock signal ICLK based on the clock signals Y and YB, and supplies the generated internal clock signal ICLK to various circuit blocks including a data input/output circuit 1263 and a data strobe signal input/output circuit 1264. In the present embodiment, the memory chip 200 includes, though not limited, no DLL circuit.

The command terminal 1252 is a terminal to which the command signal CMD including the row address strobe signal (RASB), the column address strobe signal (CASB), and the write enable signal (WEB) is supplied. The command signal CMD is supplied to a command decoder 1266. The command decoder 1266 retains, decodes, and counts the command signal in synchronization with the internal clock ICLK to generate various internal commands ICMD. The generated internal commands ICMD are supplied to various circuit blocks including a mode register 1265.

The control terminal 1256 is a terminal to which a rank-specific control signal CTRL including a chip select signal (CSB), a clock enable signal (CKE), and an on-die termination signal (ODT) is supplied. The control signal CTRL is supplied to a control circuit 1268. The control circuit 1268 generates internal control signals such as an internal on-die termination signal IODT based on the control signal CTRL.

The address terminal 1253 is a terminal to which the address signal ADD is supplied. The supplied address signal ADD is supplied to an address latch circuit 1267. The address latch circuit 1267 latches the address signal ADD in synchronization with the internal clock signal ICLK. Of the address signal ADD latched in the address latch circuit 1267, a row address is supplied to a row decoder 1271 and a column address is supplied to a column decoder 1272. When in mode register setting, the address signal ADD is supplied to the mode register 1265, whereby the content of the mode register 1265 is updated.

The row decoder 1271 is a circuit that selects any one of word lines WL included in a memory cell array 1280. The memory cell array 1280 includes a plurality of word lines WL and a plurality of bit lines BL which intersect each other. Memory cells MC are arranged at the intersections (FIG. 4 shows only one of the word lines WL, one of the bit lines BL, and one of the memory cells MC). The bit lines BL are connected to sense amplifiers SA included in a sense amplifier row 1281. The sense amplifiers SA are selected by the column decoder 1272.

The selected sense amplifiers SA are connected to the data input/output circuit 1263. The internal clock signal ICLK and an internal data strobe signal PDQS are supplied to the data input/output circuit 1263. In a read operation, the data input/output circuit 1263 outputs read data in synchronization with the internal clock signal ICLK. In a write operation, the data input/output circuit 1263 takes in write data in synchronization with the internal data strobe signal PDQS. As a result, in a read operation, the read data read from the memory cell array 1280 is output from the data input/output terminal 1254. In a write operation, the write data received from the data input/output terminal 1254 is written to the memory cell array 1280.

The data strobe terminal 1255 is a terminal for inputting and outputting a data strobe signal DQS. The data strobe terminal 1255 is connected to the data strobe signal input/output circuit 1264. The data strobe signal input/output circuit 1264 generates the foregoing internal data strobe signal PDQS, and supplies the internal data strobe signal PDQS to the data input/output circuit 1263.

The internal on-die termination signal IODT, an output of the control circuit 1268, is also supplied to the data input/output circuit 1263 and the data strobe signal input/output circuit 1264. If the internal on-die termination signal IODT is activated, both the data input/output circuit 1263 and the data strobe signal input/output circuit 1264 function as a termination resistor.

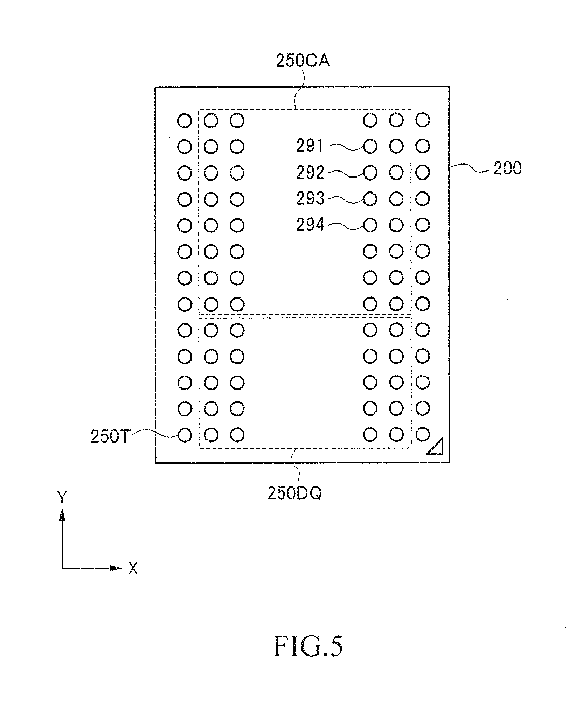

As shown in FIG. 5, the memory chip 200 includes a plurality of external terminals 250T which are laid out in a matrix configuration. In FIG. 5, the area designated by the reference number 250DQ is an area where data-system external terminals, or more specifically, the data input/output terminal 1254 and the data strobe terminal 1255 shown in FIG. 4 are arranged. The area designated by the reference number 250CA in FIG. 5 is an area where command/address-system external terminals and control-system external terminals, or more specifically, the clock terminal 1251, the command terminal 1252, the control terminal 1256, and the address terminal 1253 shown in FIG. 4 are arranged. The area 250DQ and the area 250CA are arranged in the Y directien. The area 250DQ lies closer to the orientation mark. The Y direction corresponds to the direction of the short side of the module substrate 510 as shown in FIG. 1.

The overall configuration of the memory chip 200 has been described above. Next, the configuration of the data register buffers 300 will be described.

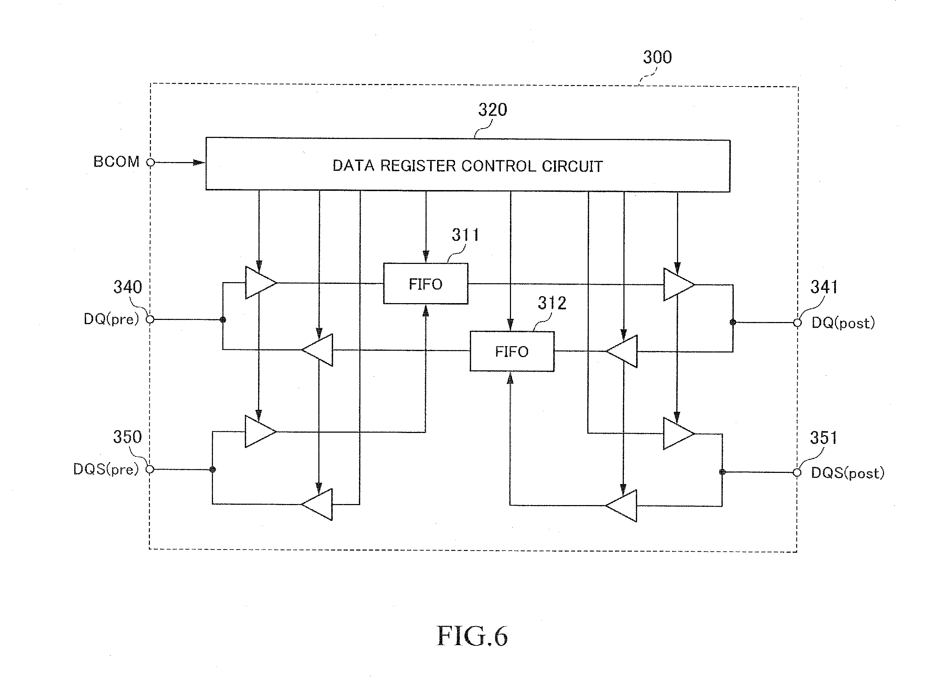

Turning to FIG. 6, the data register buffer 300 includes a write FIFO circuit 311 and a read FIFO circuit 312. The write FIFO circuit 311 buffers the write data DQ supplied through an input/output terminal 340 in synchronization with the data strobe signal DQS supplied through an input/output terminal 350. The read FIFO circuit 312 buffers the read data DQ supplied through an input/output terminal 341 in synchronization with the data strobe signal DQS supplied through an input/output terminal 351. The input/output terminals 340 and 350 are connected to data connectors 122. In FIG. 6, the signals input/output through the input/output terminals 340 and 350 have signal names accompanied by the symbol (pre). The input/output terminals 341 and 351 are terminals connected to corresponding memory chips 200. In FIG. 6, the signals input/output through the input/output terminals 341 and 351 have signal names accompanied by the symbol (post).

It should be noted that the FIFO circuits 311 and 312 shown in FIG. 6 are circuits for inputting/outputting a single bit of data. In fact, the data register buffer 300 includes FIFO circuits 311 and 312 as many as the input/output data width. For example, when a data register buffer 300 inputs/outputs a single byte of data at a time, eight pairs of FIFO circuits 311 and 312 are needed.

The operation of various buffer circuits and the FIFO circuits 311 and 312 included in the data register buffer 300 is controlled by a data register control circuit 320. The data register control circuit 320 controls the operation of the data register buffer 300 based on a control signal BCOM which is supplied from the command address register buffer 400.

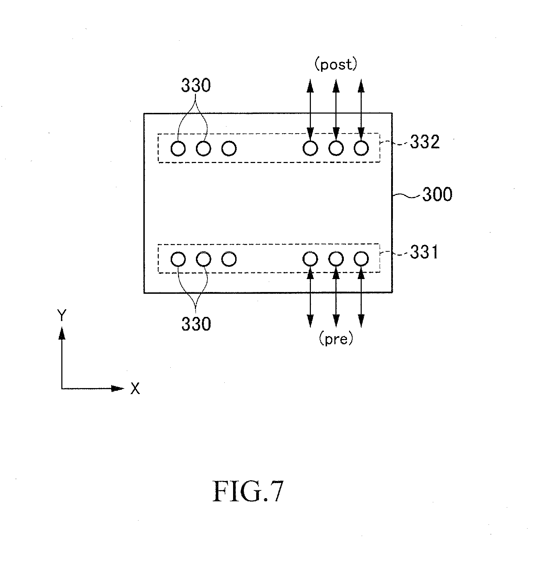

In FIG. 7, the reference numbers 330 designate external terminals belonging to data signals and data strobe signals among the external terminals formed on the data register buffer 300. As shown in FIG. 7, the external terminals of the data register buffer 300 are classified into a first group 331 and a second group 332. The first group 331 includes terminals connected to data connectors 122, including the input/output terminals 340 and 350 shown in FIG. 6. In other words, the external terminals for inputting/outputting the signals accompanied by the symbol (pre) are included. The second group 332 includes terminals connected to the corresponding memory chips 200, including the input/output terminals 341 and 351 shown in FIG. 6. In other words, the external terminals for inputting/outputting the signals accompanied by the symbol (post) are included.

As shown in FIG. 7, the first group 331 and the second group 332 are arranged in the Y direction. Each group includes a plurality of external terminals 330 arranged in the X direction.

The overall configuration of the data register buffer 300 has been described above. Next, the configuration of the command address register buffer 400 will be described.

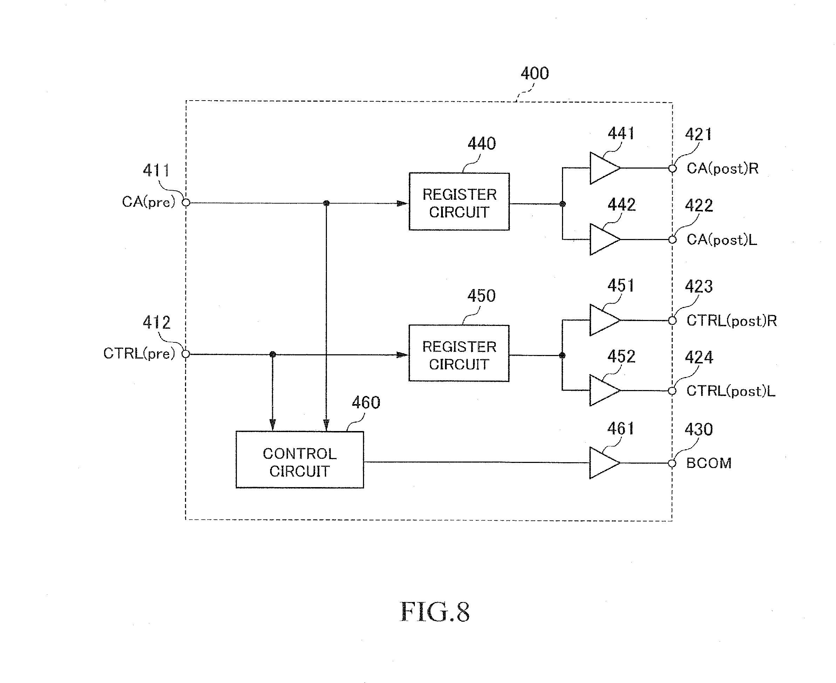

Turning to FIG. 8, the command address register buffer 400 includes input terminals 411 and 412 which are connected to the command address connectors 121, output terminals 421 to 424 which are connected to the memory chips 200, and an output terminal 430 which is connected to the data register buffers 300.

The command address signal CA and the control signal CTRL supplied from the memory controller 12 are input to the input terminals 411 and 412, respectively. In FIG. 8, the signals input to the input terminals 411 and 412 have signal names accompanied by the symbol (pre). The command address signal CA(pre) input through the input terminal 411 is buffered by a register circuit 440 before supplied to two systems of drivers 441 and 442. The drivers 441 and 442 are circuits that output a command address signal CA(post) through output terminals 421 and 422, respectively. As shown in FIG. 8, the command address signal CA(post) output from the driver 441 through the output terminal 421 is accompanied by the symbol R. The command address signal CA(post) output from the driver 442 through the output terminal 422 is accompanied by the symbol L. The command address signal CA(post)R and the command address signal CA(post)L have the same content.

Similarly, the control signal CTRL(pre) input through the input terminal 412 is buffered by a register circuit 450 before supplied to two systems of drivers 451 and 452. The drivers 451 and 452 are circuits that output a control signal CTRL (post) through output terminals 423 and 424, respectively. As shown in FIG. 8, the control signal CTRL output from the driver 451 through the output terminal 423 is accompanied by the symbol R. The control signal CTRL(post) output from the driver 452 through the output terminal 424 is accompanied by the symbol L. The control signal CTRL (post) R and the control signal CTRL(post)L have the same content.

The provision of the two output systems in the command address register buffer 400 reduces the load on the drivers 441, 442, 451, and 452.

The command address register buffer 400 further includes a control circuit 460. The control circuit 460 generates the control signal BCOM based on the command address signal CA(pre) and the control signal CTRL(pre). The generated control signal BCOM is supplied to the data register buffers 300 through a driver 461 and the output terminal 430.

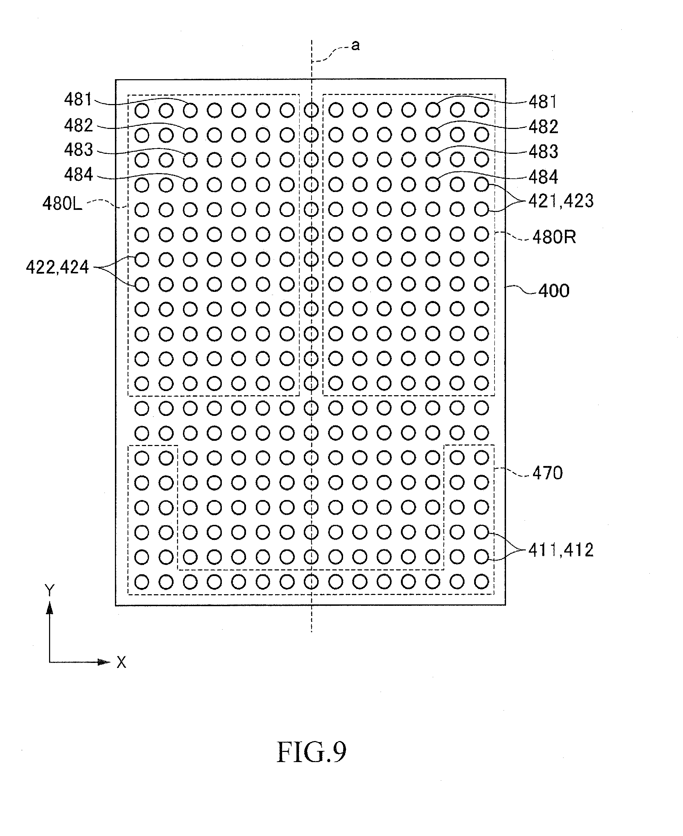

The reference number 470 shown in FIG. 9 designates an area where the input terminals 411 and 412 formed on the command address register buffer 400 are arranged. The reference number 480R shown in FIG. 9 designates an area where the output terminals 421 and 423 formed on the command address register buffer 400 are arranged. In other words, the command address signal CA(post)R and the control signal CTRL(post)R are output from the area 480R. The reference number 480L shown in FIG. 9 designates an area where the output terminals 422 and 424 formed on the command address register buffer 400 are arranged. The command address signal CA(post)L and the control signal CTRL(post)L are output from the area 480L.

The command address signal CA(post)R and the control signal CTRL (post) R are supplied to the memory chips 200 that are mounted on the right side of the module substrate 510. The command address signal CA(post)L and the control signal CTRL(post)L are supplied to the memory chips 200 that are mounted on the left side of the module substrate 510. The output terminals 421 and 423 arranged in the area 480R and the output terminals 422 and 424 arranged in the area 480L are symmetrically laid out about the center axis a. The center axis a refers to the center line in the X direction, extending in the Y direction. For example, the signals output from terminals 481 to 484 arranged in the area 480R are the same as the signals output from terminals 481 to 484 arranged in the area 480L, respectively.

The overall configuration of the command address register buffer 400 has been described above. As described above, the memory module 500 according to this embodiment of the present invention includes two command address register buffers 401 and 402. The command address register buffers 401 and 402 are chips having the same configuration. The command address register buffer 401 is mounted on one of the main surfaces 510a of the module substrate 510. The command address register buffer 402 is mounted on the other main surface 510b of the module substrate 510. The mounting direction of the command address register buffer 401 with respect to the one main surface 510a and the mounting direction of the command address register buffer 402 with respect to the other main surface 510b are 180° different from each other. Consequently, the areas 470 of the command address register buffers 401 and 402 where the input terminals 411 and 412 are arranged are opposed to each other.

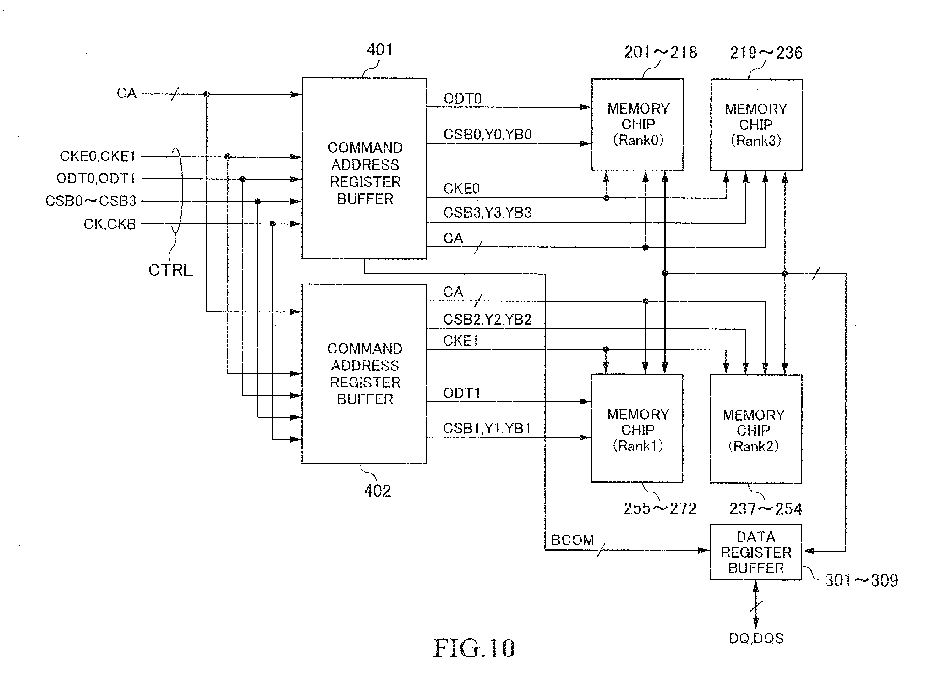

Next, the connections of the devices on the module substrate 510 will be described with reference to FIG. 10.

As shown in FIG. 10, the memory module 500 according to the present embodiment has a so-called four-rank configuration including rank0 to rank3. The ranks are exclusively activated by respective chip select signals CS0B to CS3B. In the present embodiment, the memory chips 201 to 218 constitute rank0. The memory chips 255 to 272 constitute rank1. The memory chips 237 to 254 constitute rank2. The memory chips 219 to 236 constitute rank3. Clocks signals Y0 to Y3 and YB0 to YB3 are supplied to the respective corresponding ranks. Rank0 and rank3 share a clock enable signal CKE0. Rank1 and rank2 share a clock enable signal CKE1. On-die termination signals ODT0 and ODT1 are supplied to the rank0 and rank1, respectively. No on-die termination signal is supplied to rank2 and rank3.

In this embodiment, the command address register buffer 401 is allocated to the memory chips 200 belonging to rank0 and rank3. The command address register buffer 402 is allocated to the memory chips 200 belonging to rank1 and rank2. The signal for controlling the data register buffers 300 is supplied only from the command address register buffer 401, not from the command address register buffer 402. The reason is that the data register buffers 300 perform the same operations on each rank, and the same control signal BCOM need not be supplied from both the command address register buffers 401 and 402.

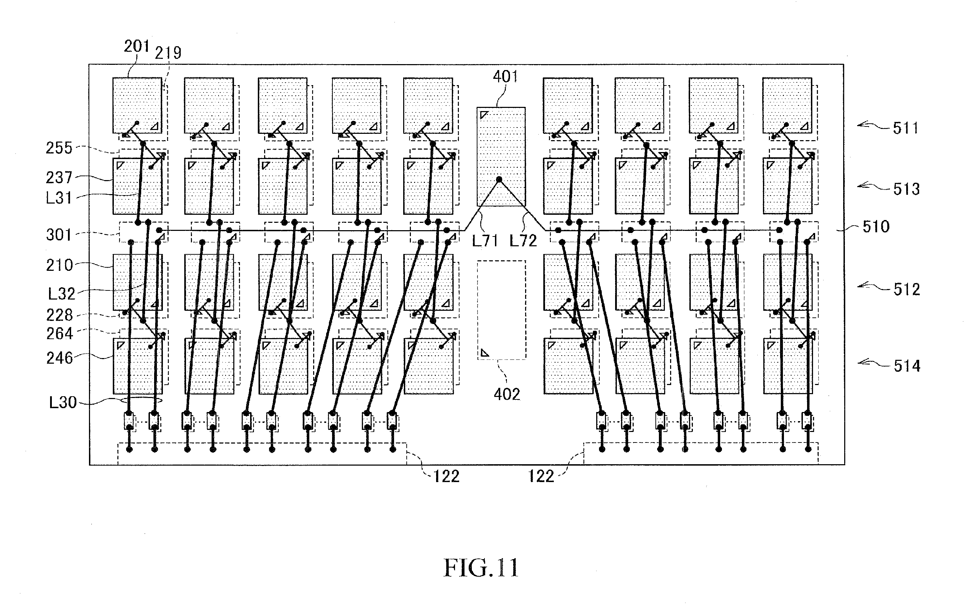

The flow of data-system signals in a write operation will initially be described. As shown in FIG. 11, write data DQ input to the data connectors 122 is supplied to the data register buffers 300 through stub resistors 130. The stub resistors 130 are provided to prevent signal reflection due to an impedance mismatch occurring in the data connectors 122. Note that the provision of the stub resistors 130 is not essential for the present invention. According to the present embodiment, the data register buffers 300 are mounted on the register mounting areas B1 and B2 which are sandwiched between the second row 512 and the third row 513 when seen in a plan view. The distances from the data connectors 112 to the data register buffers 300 are relatively large. Data lines L30 connecting the data connectors 122 and the data register buffers 300 thus have large wiring lengths, which facilitate signal reflection. The stub resistors 130 are therefore desirably provided to prevent the signal reflection.

The write data DQ input to each data register buffer 300 is buffered by the data register buffer 300 before supplied to corresponding memory chips 200. As described previously, the corresponding memory chips 200 refer to the eight memory chips 200 having the same X coordinate as that of the data register buffer 300. For example, the write data DQ output from the data register buffer 301 is supplied to the four memory chips 201, 210, 219, 228, 237, 246, 255 and 264. In a read operation, the flow of data-system signals is reverse to the foregoing. Read data DQ read from two memory chips belonging to a selected rank is supplied to the corresponding data register buffer 300. The read data DQ is buffered by the data register buffer 300 before supplied to the data connectors 122 through the stub resistors 130.

In the present embodiment, half the input/output terminals 341 and 351 formed on the data register buffers 300 (see FIG. 6) are connected to lines L31. The other half are connected to lines L32. The lines L31 extend upward when seen from the data register buffers 300. Each line L31 is branched out between the first row 511 and the third row 513 and connected to the corresponding four memory chips 200 in common. Similarly, the lines L32 extend downward when seen from the data register buffers 300. Each line L32 is branched out between the second row 512 and the fourth row 514 and connected to the corresponding four memory chips 200 in common. The lines L31 and the lines L32 have almost the same lengths. Besides, the wiring distances from the branching points of the lines L31 and L32 to the respective memory chips 200 are almost the same.

As shown in FIG. 11, in the present embodiment, the memory chips 200 belonging to the first row 511 and the memory chips 200 belonging to the third row 513 are mounted in 180° different directions. The branching points of the lines L31 are located between the memory chips 200. Similarly, the memory chips 200 belonging to the second row 512 and the memory chips 200 belonging to the fourth row 514 are mounted in 180° different directions. The branching points of the lines L32 are located between the memory chips 200.

With such a configuration, the data-system wiring on the module substrate 510 can be laid out so that the wiring lengths between the data register buffers 300 and the respective corresponding eight memory chips 200 are the smallest and constant. In a write operation, write data DQ therefore reach the memory chips 200 mounted on the respective rows almost at the same time. In a read operation, read data DQ output from the memory chips 200 mounted on the respective rows reach the data register buffers 300 almost at the same time. Data skew depending on the mounting positions of the memory chips 200 is thus significantly reduced like the first embodiment. As a result, data can be properly input and output without the implementation of synchronous circuits such as a DLL circuit on the memory chips 200. The ranks have little difference in the data skew, either.

The command address register buffer 401 and the data register buffers 301 to 305 are connected by a line L71. The command address register buffer 401 and the data register buffers 306 to 309 are connected by a line L72. As described above, the command address register buffer 402 is not connected with the data register buffers 301 to 309.

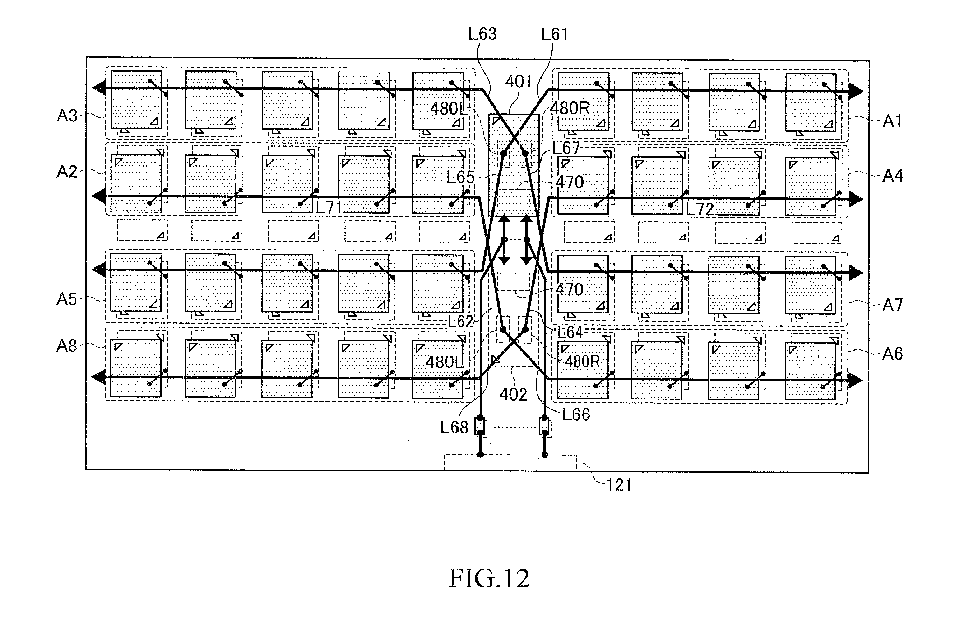

As shown in FIG. 12, the command address signal CA and the control signal CTRL input to the command address connectors 121 are supplied to the command address register buffers 401 and 402 through the stub resistors 130. The command address register buffers 401 and 402 buffer the command address signal CA and the control signal CTRL, and supplies the signals to the memory chips 200 through the output terminals 421 to 424. The command address signal CA outputted from the command address register buffers 401 and 402 is supplied to all of the memory chips 201 to 272 in common. On the contrary, the control signal CTRL outputted from the command address register buffers 401 and 402 is individually supplied to each of the ranks. Therefore, only one of the ranks is selectively activated.

Here, a connection relationship between the command address register buffers 401 and 402 and the memory chips 200 will be explained in detail. As shown in FIG. 12, the memory chips 200 mounted on the first to eighth memory mounting area A1 to A8 are connected to the lines L61 to L68, respectively. For example, the memory chips 201 to 205 and 219 and 223 mounted on the third memory mounting area A3 are connected in common to the line L63. As shown in FIG. 12, the lines L61 and L65 are connected in common to the area 480L of the command address register buffer 401, the lines L63 and L67 are connected in common to the area 480R of the command address register buffer 401, the lines L64 and L68 are connected in common to the area 480R of the command address register buffer 402, and the lines J62 and L66 are connected in common to the area 480L of the command address register buffer 402.

The line L61 and the line L65 are two lines branched from the area 480L of the command address register buffer 401. The line L63 and the line L67 are two lines branched from the area 480R of the command address register buffer 401. The line L64 and the line L68 are two lines branched from the area 480R of the command address register buffer 402. The line L62 and the line L66 are two lines branched from the area 480L of the command address register buffer 402.

In the present embodiment, the two command address register buffers 401 and 402 are used to supply the command address signal CA and the control signal CTRL to the memory chips 200 through respective different lines. The load of the lines L61 to L68 is thus reduced by half as compared in the case where only one command address register buffer 401 is used. This means that the load for the drivers 441, 442, 451, and 452 to drive is reduced by half. Even if the used clock signals CK and CKB have a high frequency, the command address signal CA and the control signal CTRL can thus be maintained at high signal quality.

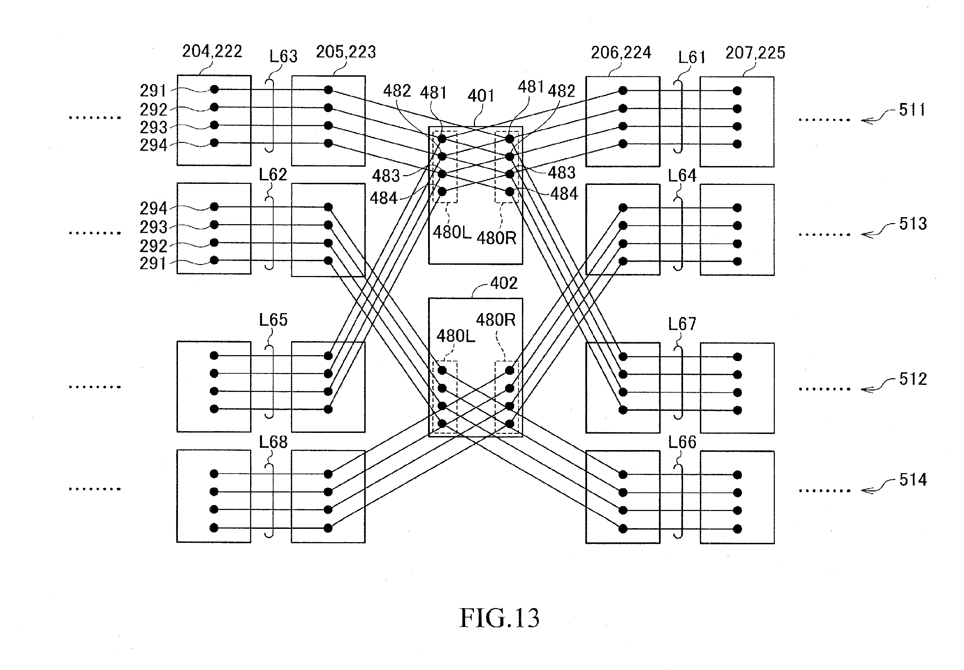

The connections between the command address register buffers 401 and 402 and the memory chips 200 will be explained in more detail with reference to FIG. 13.

In FIG. 13, the terminals 481 to 484 formed on the command address register buffers 401 and 402 correspond to the terminals 481 to 484 shown in FIG. 9. More specifically, the terminals 481 to 484 are arranged in the Y direction. The signals output from the terminals 481 to 484 arranged in the areas 480R are the same as those output from the terminals 481 to 484 arranged in the areas 480L. The signals output from the terminals 481 to 484 are supplied to terminals 291 to 294 formed on the memory chips 200, respectively. As shown in FIG. 5, the terminals 291 to 294 are formed in the area 250CA and arranged in the Y direction.

In the present embodiment, the command address register buffer 401 is allocated to the memory chips 201 to 236 which are mounted in the same directions in the first row 511 and the second row 512. The command address register buffer 402 is allocated to the memory chips 237 to 272 which are mounted in the same directions in the third row 513 and the fourth row 514. The memory chips 201 to 236 and the memory chips 237 to 272 are mounted in 180° different directions. The command address register buffer 401 and the command address register buffer 402 are mounted in 180° different directions. As shown in FIG. 13, a plurality of lines included in each of the lines L61 to L68 (in the example shown in FIG. 13, four lines each) can be connected to the terminals 291 to 294 of the memory chips 201 to 272 without changing the arrangement order in the Y direction.

Consequently, the lines L61 to L68 can be arranged in a simple layout, with a reduction in the wiring density inside the module substrate 510. According to the present embodiment, the command address signals CA and the control signals CTRL output from the areas 480R and 480L have only to be branched into two each. The number of wiring layers needed for the branching is only two. The number of wiring layers of the module substrate 510 can thus be reduced to reduce the substrate cost. Moreover, according to the present embodiment, the lines L61 to L68 have little difference in load because the same numbers of memory chips 200 are connected to the terminals 481 to 484 of the command address register buffers 401 and 402. The lines L61 to L68 can also be made the same in length.

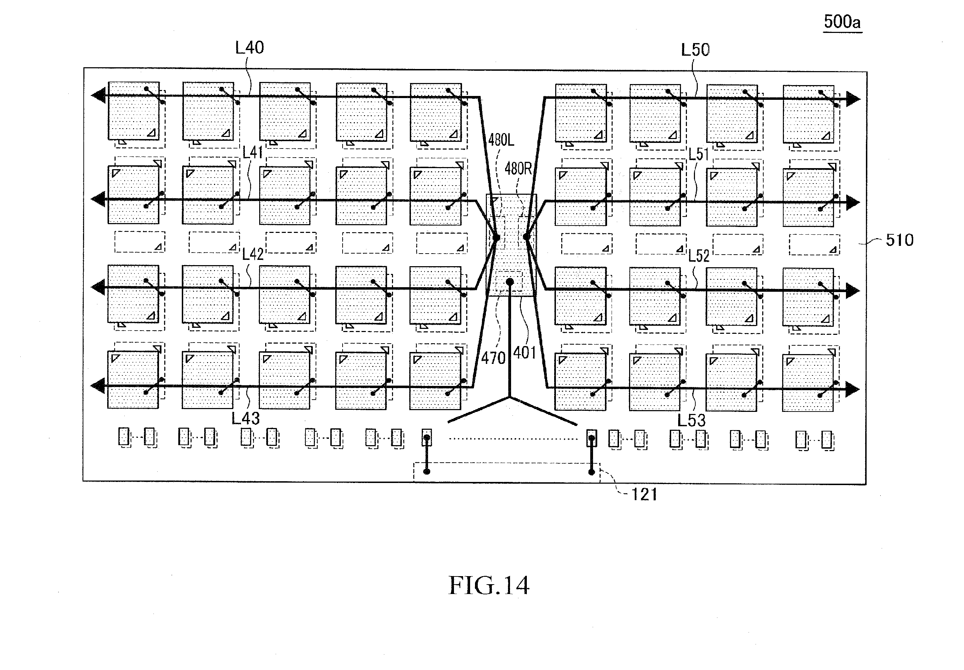

The prototype memory module which the inventors have conceived in the process of achieving the present invention will be explained with reference to FIG. 14.

In the prototype memory module 500a shown in FIG. 14, only one command address register buffer 401 is mounted on the module substrate 510. In this prototype memory module, the command address signal CA and the control signal CTRL are supplied to the memory chips 200 mounted on the right side of the module substrate 510 via the output terminals 421 and 423 provided on the area 480R and lines L50 to L53. The command address signal CA and the control signal CTRL are supplied to the memory chips 200 mounted on the left side of the module substrate 510 via the output terminals 422 and 424 provided on the area 480L and lines L40 to L43.

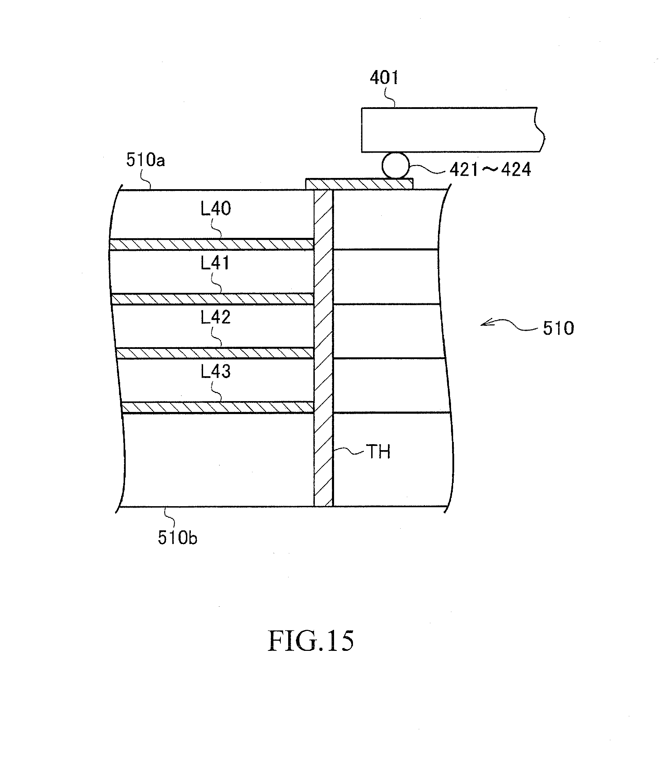

In this prototype memory module, the command address signal CA and the control signal CTRL are supplied to the memory chips 200 mounted on the first to fourth rows 511 to 514 via an associated one of four lines branched from the area 480L or 480R. In order to branch a signal line into four in the module substrate 510, four wiring layers may be used as shown in FIG. 15, for example. The lines L40 to L43 formed on the respective wiring layers need to be connected to the same through hole conductor TH. Therefore, the number of wiring layers that is needed to be provided to the module substrate 510 increases with respect to the first embodiment described above.

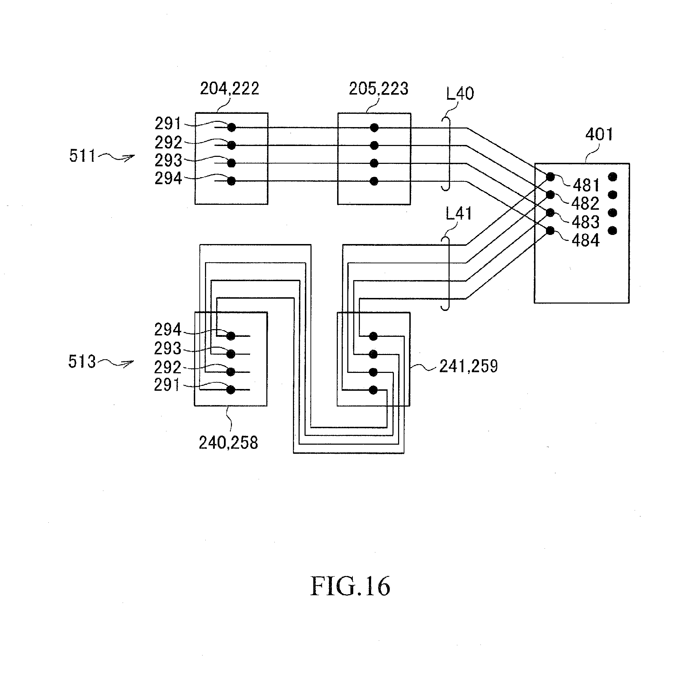

According to the prototype memory module, as shown in FIG. 16 that indicates a connection relationship between the command address register buffer 401 and the memory chips 200 in more detail, the lines L40 can layout in simple whereas the lines L41 cannot layout in simple but layout in a meander shape in order to connect the terminals 481 to 484 of the command address register buffer 401 to the terminals 291 to 294 of the memory chips 200, respectively. This results in increasing a wiring density and a wiring length. If the wiring length of the lines L40 is necessary to match with that of the lines L41, the lines L40 is needed to layout in a meander shape to lengthen thereof whereas the lines L40 is not necessary to originally layout in a meander shape. Although only the lines L40 and L41 are shown in FIG. 16, the lines L43, L51 and L53 are also necessary to layout in a meander shape in the prototype memory module 500a.

As can be seen from foregoing, the wiring density on the module substrate 510 is inevitably increased according to the prototype memory module 500a. In addition, a load capacitance of the lines L40 to L43 and L50 to L53 is inevitably increased because only one command address register buffer 401 is used in the prototype memory module 500a. In contrast, all the problems described above can be solved by the memory module 500 according to the first embodiment of the present invention. That is, according to the memory module 500 of the present embodiment, not only a wiring density on the module substrate 510 can be reduced but also a load capacitance of the lines L61 to L68 can be reduced by half as compared to the prototype memory module 500a.

Next, a second preferred embodiment of the present invention will be described.

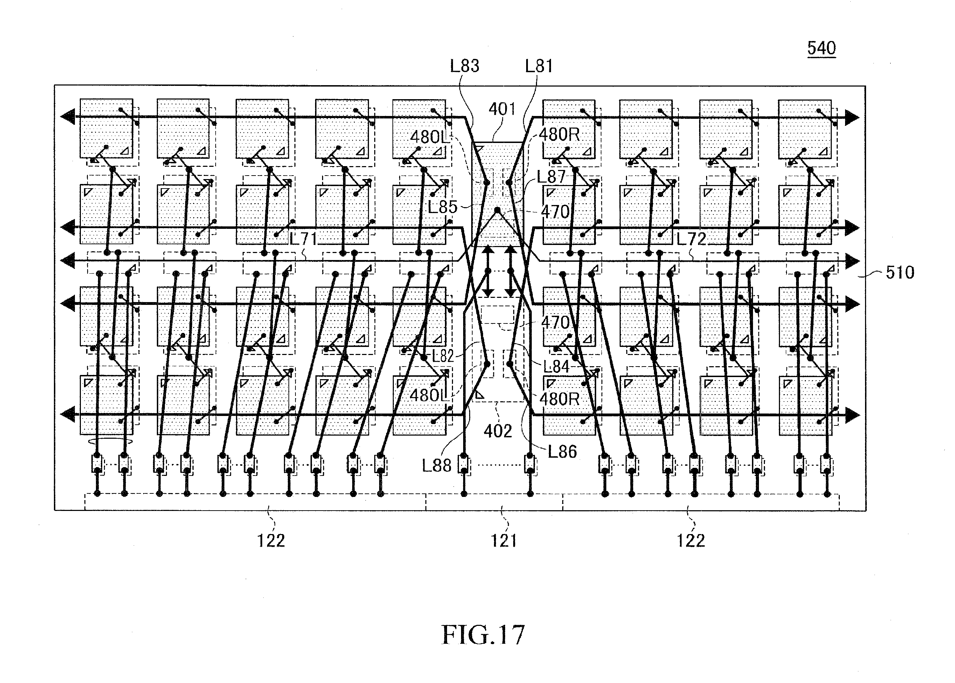

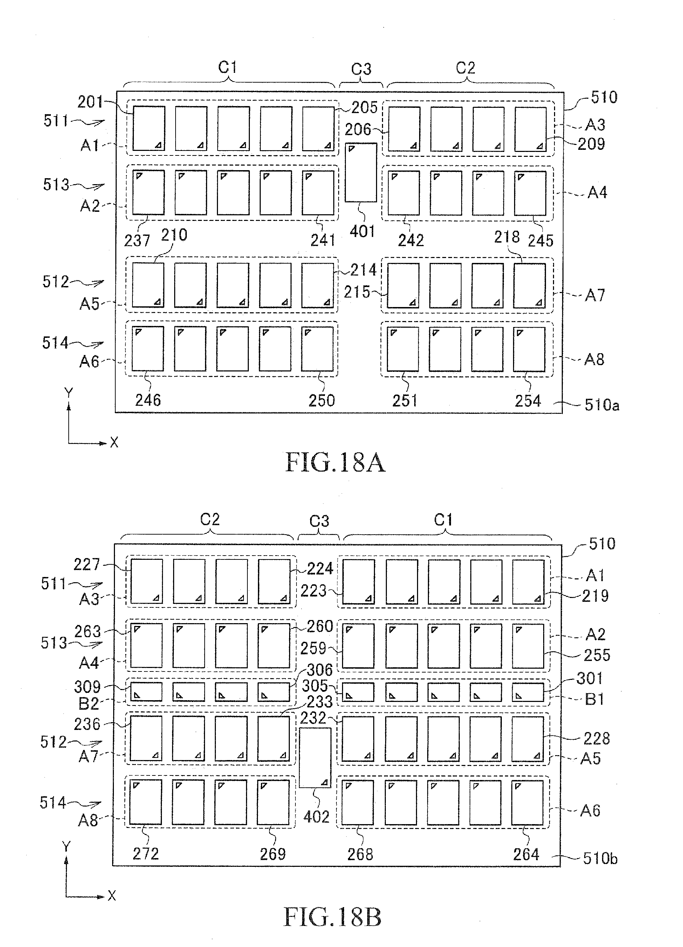

As shown in FIG. 17, the memory module 540 according to the second embodiment of the present invention differs from the memory module 500 of the first embodiment in the connection relationship between the command address register buffers 401 and 40% and the memory chips 200. in other respects, the memory module 540 is basically the same as the memory module 500 according the first embodiment. Like parts will thus be designated by the same reference numbers. Redundant description will be omitted. As shown in FIGs. 18A and 18B, a designation of the first to eighth memory mounting areas A1 to A8 is different from the first embodiment. As shown in FIGs. 18A and 18B, the first, second, fifth, and sixth memory mounting areas A1, A2, A5, and A6 are arranged in this order on the first region C1, and the third, fourth, seventh, and eighth memory mounting areas A3, A4, A7, and A8 are arranged in this order on the second region C2.

In this embodiment, the memory chips 200 mounted on the first to eighth memory mounting areas A1 to A8 are connected to the lines L81 to L88, respectively. For example, the memory chips 201 to 205 and 219 to 223 mounted on the third memory mounting area A3 are connected in common to the line L83. As shown in FIG. 17, the lines L83 and L85 are connected in common to the area 480L of the command address register buffer 401, the lines L81 and L87 are connected in common to the area 480R of the command address register buffer 401, the lines L82 and L88 are connected in common to the area 480L of the command address register buffer 402, and the lines L84 and L86 are connected in common to the area 480R of the command address register buffer 402.

The line L83 and the line L85 are two lines branched from the area 480L of the command address register buffer 401. The line L81 and the line L87 are two lines branched from the area 480R of the command address register buffer 401. The line L82 and the line L88 are two lines branched from the area 480L of the command address register buffer 402. The line L84 and the line L86 are two lines branched from the area 480R of the command address register buffer 402.

With such a configuration, the present embodiment can provide almost the same effects as those of the memory module 500 according to the foregoing first embodiment. In the present embodiment, corresponding two of the lines L81 to L88 have the same load and the same wiring length. For example, the line L83 and the line L85 both are branched from the area 480L of the command address register buffer 401. The lines L83 and L85 are connected to the same numbers of memory chips 200 and have almost the same wiring lengths. According to the present embodiment, the command address signal CA and the control signal CTRL can thus be improved in signal integrity.

Next, a third preferred embodiment of the present invention will be described.

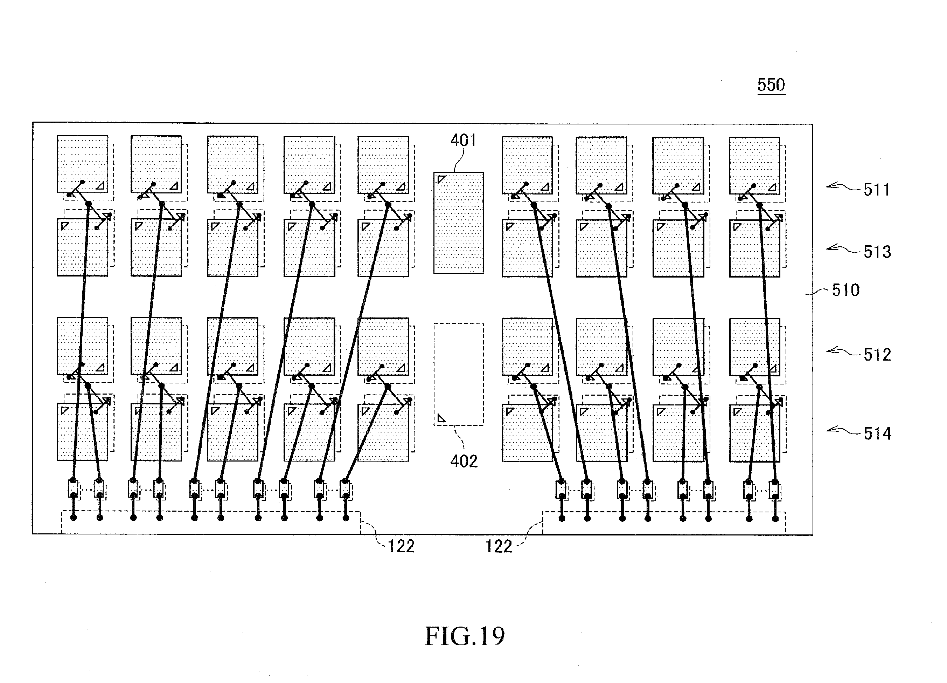

As shown in FIG. 19, the memory module 550 according to the third embodiment of the present invention differs from the memory module 500 of the first embodiment in that the data register buffers 301 to 309 are omitted. In other respects, the memory module 550 is basically the same as the memory module 500 according the first embodiment. Like parts will thus be designated by the same reference numbers. Redundant description will be omitted. The memory module 550 according to the third embodiment can basically provide the same effects as those of the memory module 500 according to the first embodiment except that a load capacitance of the data lines viewed from the memory controller 12 is large compared with the first embodiment because the memory chips 200 are connected in direct to the data connectors 122. Instead, a cost of the memory module 550 can be lowered because the data register buffers 301 to 309 are omitted. The connection relationship between the command address register buffers 401 and 402 and the memory chips 200 can be the same as that of the first embodiment or that of the second embodiment.

Next, a fourth preferred embodiment of the present invention will be described.

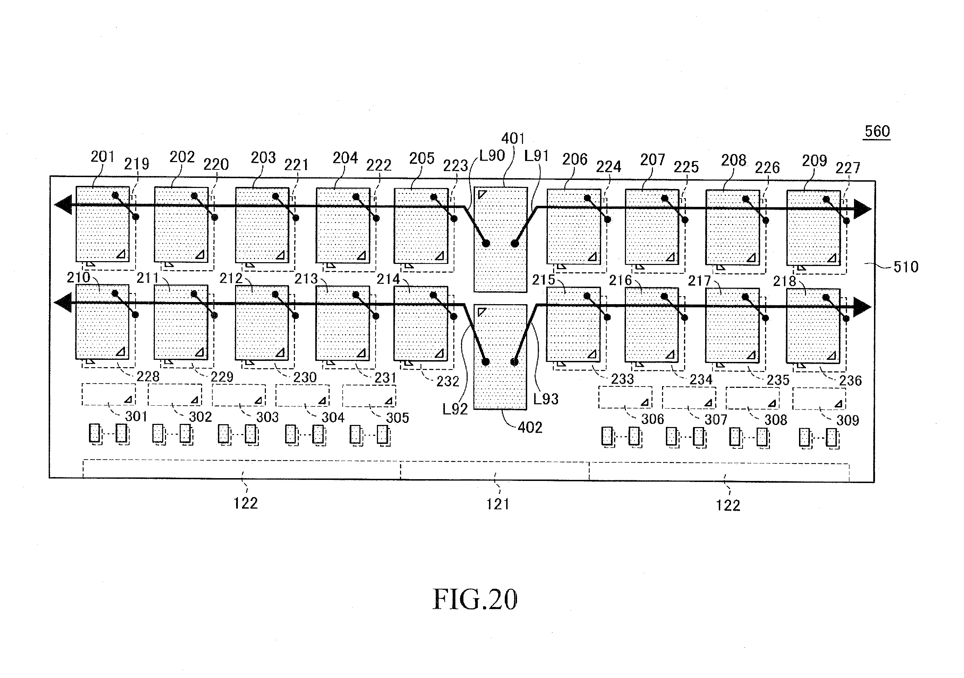

As shown in FIG. 20, the memory module 560 according to the fourth embodiment of the present invention has a four-rank configuration and differs from the memory module 500 of the first embodiment in that the memory chips 237 to 272 are omitted. The command address register buffer 401 supplies the command address signal CA and the control signal CTRL to the memory chips 201 to 209 and 219 to 227 via the lines L90 and L91. The command address register buffer 402 supplies the command address signal CA and the control signal CTRL to the memory chips 210 to 218 and 228 to 236 via the lines L92 and L93. In the present embodiment, the memory chips 201 to 218 constitute the rank0 and the memory chips 219 to 236 constitute the rank1. According to the embodiment, because a plurality of command address register buffers 401 and 402 are used, a load capacitance of the lines L90 to L93 can be reduced compared with when only one command address register buffer 401 are used.

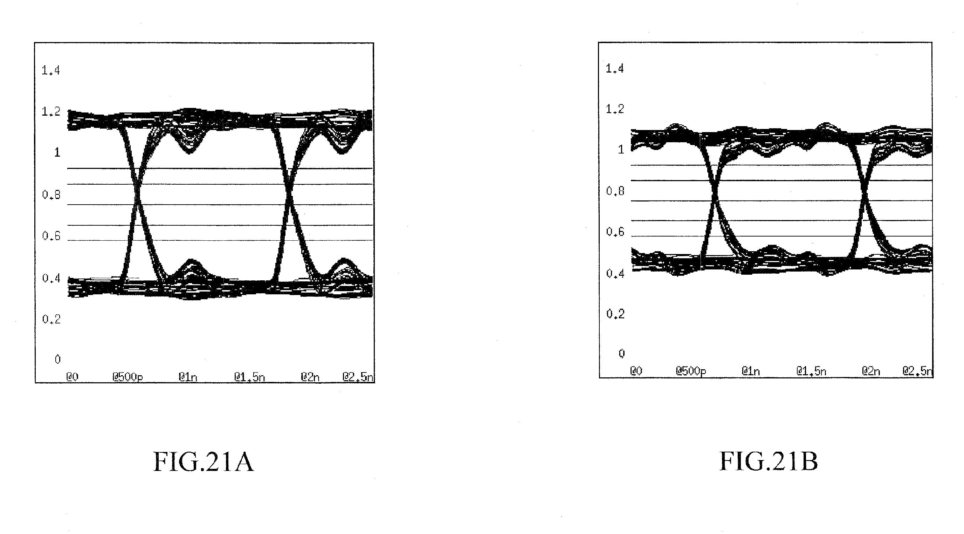

FIG. 21A shows an eye pattern of the command address signals CA and the control signals CTRL according to the first and second embodiments. FIG. 21B shows an eye pattern of the command address signals CA and the control signals CTRL according to the prototype example shown in FIG. 14. Both patterns show the signal waveforms on the module substrate that appeared on the memory chips 200 when the clock signals CK and CKB were set to a frequency of 400 MHz. As shown in FIGs. 21A and 21B, the first and second embodiments are found to provide a more favorable eye pattern than the prototype example. The reason is considered to be that the command address signal CA and the control signal CTRL output from the command address register buffer 401 are branched into four inside the module substrate 510 according to the prototype example, whereas the first and second embodiments include only branching into two.

It is apparent that the present invention is not limited to the above embodiments, but may be modified and changed without departing from the scope and spirit of the invention.

For example, in the foregoing embodiments, DRAMs are used as the memory chips 200. The present invention is not limited thereto, and other types of memory devices may be used. The memory devices to be mounted may each include a memory chip packaged in a single package. A device including two or more memory chips packaged in a single package may be used.

In addition, in the foregoing embodiments, two command address register buffers are mounted on the module substrate. However, the present invention is not limited thereto, and three or more command address register buffers may be mounted on the module substrate.

## Claims

1. A memory module comprising:
a module substrate;
a plurality of command address connectors formed on the module substrate, the command address connectors receiving a command address signal from outside;
a plurality of memory devices mounted on the module substrate, the memory devices including a plurality of first memory devices and a plurality of second memory devices; and
a plurality of command address register buffers mounted on the module substrate, the command address register buffers including a first command address register buffer that supplies the command address signal to the first memory devices and a second command address register buffer that supplies the command address signal to the second memory devices.

2. The memory module as claimed in claim 1, wherein
the module substrate includes a memory mounting area having a first and second regions arranged in a first direction, the module substrate further including a third region arranged between the first and second regions,
the memory mounting area includes first, second, third and fourth memory mounting areas,
the memory devices further include a plurality of third memory devices and a plurality of fourth memory devices,
the first, second, third and fourth memory devices are mounted on the first, second, third and fourth memory mounting areas, respectively,
the first and second command address register buffers are mounted on the third region,
the first command address register buffer includes a first output terminal that outputs the command address signal to the first memory devices and a third output terminal that outputs the command address signal to the third memory devices, and
the second command address register buffer includes a second output terminal that outputs the command address signal to the second memory devices and a fourth output terminal that outputs the command address signal to the fourth memory devices.

3. The memory module as claimed in claim 2, wherein the first and second command address register buffers are arranged in a second direction crossing the first direction in the planner view.

4. The memory module as claimed in claim 3, wherein the first and second output terminals are located at the first region side in the third region, and the third and fourth output terminals are located at the second region side in the third region.

5. The memory module as claimed in claim 3 or 4, wherein the first command address register buffer is mounted on one main surface of the module substrate, and the second command address register buffer is mounted on the other main surface of the module substrate.

6. The memory module as claimed in claim 5, wherein a mounting direction of the first command address register buffer with respect to the one main surface of the module substrate and a mounting direction of the second command address register buffer with respect to the other main surface of the module substrate are 180° different from each other.

7. The memory module as claimed in any one of claims 2 to 6, wherein
the memory mounting area further includes fifth, sixth, seventh and eighth memory mounting areas,
the memory devices further include a plurality of fifth memory devices, a plurality of sixth memory devices, a plurality of seventh memory devices, and a plurality of eighth memory devices,
the fifth, sixth, seventh and eighth memory devices are mounted on the fifth, sixth, seventh and eighth memory mounting areas, respectively,
the first output terminal of the first command address register buffer outputs the command address signal to the fifth memory devices,
the third output terminal of the first command address register buffer outputs the command address signal to the seventh memory devices,
the second output terminal of the second command address register buffer outputs the command address signal to the sixth memory devices, and
the fourth output terminal of the second command address register buffer outputs the command address signal to the eighth memory devices.

8. The memory module as claimed in claim 7, wherein the second, third, fifth and eighth memory mounting areas are located at the first region, and the first, fourth, sixth and seventh memory mounting areas are located at the second region.

9. The memory module as claimed in claim 8, wherein the third, second, fifth and eighth memory mounting areas are arranged in this order in the first region, and the first, fourth, seventh and sixth memory mounting areas are arranged in this order in the second region.

10. The memory module as claimed in claim 7, wherein the first, second, fifth and sixth memory mounting areas are located at the first region, and the third, fourth, seventh and eighth memory mounting areas are located at the second region.

11. The memory module as claimed in claim 10, wherein the first, second, fifth and sixth memory mounting areas are arranged in this order in the first region, and the third, fourth, seventh and eighth memory mounting areas are arranged in this order in the second region.

12. The memory module as claimed in any one of claims 7 to 11, further comprising:
a plurality of data connectors formed on the module substrate; and
a plurality of data register buffers mounted on the module substrate, the data register buffers transferring write data supplied from the data connectors to the memory devices, and transferring read data supplied from the memory devices to the data connectors,
wherein the data register buffers are arranged between the second and fifth memory mounting areas and between the fourth and seventh memory mounting areas.

13. The memory module as claimed in claim 12, wherein
each ones of the first to eighth memory devices are arranged in the first direction in associated one of the first to eighth memory mounting areas, and
each of the data register buffers and associated ones of the first to eighth memory devices connected thereto are arranged in a second direction crossing the first direction in the planner view.

14. The memory module as claimed in any one of claims 1 to 13, wherein each of the memory devices includes one or more memory chips.
